# EUROPÄISCHE PATENTSCHRIFT

(11) **EP 1 192 672 B1**
(45) Veröffentlichungstag und Bekanntmachung des Hinweises auf die Patenterteilung: **09.11.2005**
(21) Anmeldenummer: 00949054.1
(22) Anmeldetag: 20.05.2000
(51) Int. Cl.: H01L 41/083, H01L 41/047

(54) **PIEZOELEMENT MIT EINEM MITTELS FALTUNG HERGESTELLTEN MEHRSCHICHTAUFBAU**
PIEZO ELEMENT WITH A MULTIPLE-LAYER STRUCTURE PRODUCED BY FOLDING
ELEMENT PIEZO-ELECTRIQUE AYANT UNE STRUCTURE MULTICOUCHE OBTENUE PAR PLIAGE

(30) Priorität: 19.06.1999 DE 19928181
(43) Veröffentlichungstag der Anmeldung: 03.04.2002
(73) Patentinhaber: ROBERT BOSCH GMBH, 70442 Stuttgart (DE)
(72) Erfinder: BOECKING, Friedrich, D-70499 Stuttgart (DE)
(86) Internationale Anmeldenummer: PCT/DE2000/001628
(87) Internationale Veröffentlichungsnummer: WO 2000/079612

(56) Entgegenhaltungen:
- EP-A- 0 844 678
- PATENT ABSTRACTS OF JAPAN vol. 013, no. 310 (M-850), 14. Juli 1989 (1989-07-14) & JP 01 097604 A (MITSUBISHI KASEI CORP), 17. April 1989 (1989-04-17) -& JP 01 097604 A (MITSUBISHI KASEI CORP) 17. April 1989 (1989-04-17)
- LEE J K ET AL: "Multilayered piezoelectric flexure device" RESEARCH DISCLOSURE, Bd. 187, November 1979 (1979-11), Seiten 627-628, XP002148391 ISSN 0374-4353

## Beschreibung

### Stand der Technik

Die Erfindung betrifft ein Piezoelement mit einem Mehrschichtaufbau von Piezolagen und ein Verfahren zu dessen Herstellung, beispielsweise für einen Piezoaktor zur Betätigung eines mechanischen Bauteils wie ein Ventil oder dergleichen, nach den gattungsgemäßen Merkmalen des Hauptanspruchs.

Ein derartiges Piezoelement ist beispielsweise durch die JP 01097604 A bekannt geworden.

Es ist allgemein bekannt, dass unter Ausnutzung des so genannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden. Die jeweiligen Innenelektroden sind hierbei jeweils gegenüber den Außenelektroden um einen Bereich versetzt, damit hier kein Kurzschluss erfolgt. Der Aufwand beim Stapeln der einzelnen Piezolagen ist dabei sehr hoch, da bis zu mehrere Hundert einzelne Folienschichten separat verarbeitet werden müssen.

Die Piezolagen des aus der eingangs genannten JP 01097604 A bekannten Piezoelements sind durch Falten einer folienartig ausgeformten keramischen Masse mit organischem Binder "(green sheet") gebildet, auf die beidseitig Elektroden aufgebracht sind. Diese Elektroden werden wechselseitig jeweils von einer seitlich Außenelektrode kontaktiert.

Aus dem Artikel von J. K. Lee et al., "Multilayered piezoelectric flexure device", Research Disclosure, Bd. 187, November 1979 (1979-11), Seiten 627-628, XP002148391 ISSN 0374-4353, ist weiterhin ein Piezoelement bekannt, dessen Piezolagen durch Falten einer durchgängigen Folie ("plastic piezoelectric film preferably polyvinylidene fluoride") gebildet sind, welche beidseitig Elektroden aufweist. In die Falten des gefalteten Piezostapels werden jeweils von beiden Seiten Kontaktfinger einer Außenelektrode eingeschoben, um die Elektroden der Folie zu kontaktieren.

### Vorteile der Erfindung

Das eingangs beschriebene Piezoelement mit einem Mehrschichtaufbau von Piezolagen, mit dazwischen angeordneten Elektroden und einer wechselseitigen seitlichen Kontaktierung der Elektroden, kann in vorteilhafter Weise Bestandteil eines Piezoaktors sein, der zur Betätigung eines mechanischen Bauteils wie ein Ventil oder dergleichen benutzt werden kann. Erfindungsgemäß bestehen die einzelnen Piezolagen aus einer während der Herstellung faltbaren durchgängigen Folie und bestehen die Außenelektroden aus einem elektrisch leitenden Sieb oder Netz oder aus Wellelektroden, wobei der Mehrschichtaufbau der Piezolagen jeweils am Ende der gefalteten Lagen mit einer elektrisch isolierenden Keramikplatte versehen ist.

Bei einer bevorzugten Ausführungsform ist die Folie durch Aufbringen von Lösungsmitteln in vorteilhafter Weise biegbar gemacht worden und beidseitig bis auf einen vorgegebenen Bereich an den Enden in Längsrichtung zur Herstellung der Elektroden metallisiert, beispielsweise auch durch Bedrucken oder Sputtern. Hierbei sind die vorgegebenen Bereiche ohne Elektrodenmaterial am Ende der gefalteten Schichten vorgesehen um keinen Kurzschluss im Piezoelement nach dem Anbringen von Außenelektroden hervorzurufen.

Bei einem vorteilhaften Verfahren zur Herstellung eines Piezoelements der zuvor beschriebenen Art werden folgende Herstellungsschritte durchgeführt:
- Die Piezofolie ist durch das Lösungsmittel biegbar und wird in der Breite des Piezoelements geschnitten.
- Die Piezofolie wird auf beiden Seiten bis auf die vorgegebenen Endbereiche metallisiert.
- In vorgegebenen Abständen wird die Piezofolie durch Biegung gefaltet.
- Das gefaltete Paket wird laminiert.
- Das gefaltete Paket wird gesintert.
- Die Außenelektroden werden mittels löten auf die metallisierte Schicht im Biegebereich aufgebracht.
- Alternativ vor dem sintern: Auf die äußeren Piezolagen wird jeweils eine elektrisch isolierende Kopf- und Fußplatte aus Piezokeramik aufgebracht.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

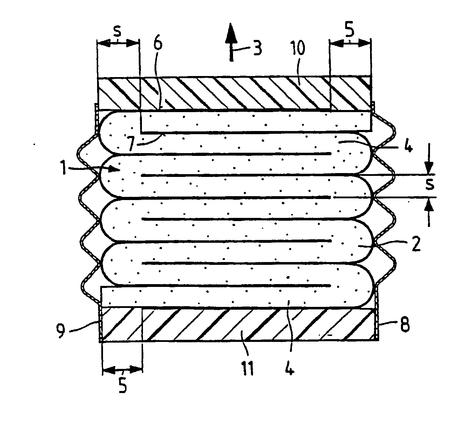

Ein Ausführungsbeispiel des erfindungsgemäßen Piezoelements zur Bildung eines Piezoaktors wird anhand der Figur der Zeichnung erläutert, die einen Schnitt durch einen Mehrschichtaufbau des Piezoelements zeigt, der durch Faltung hergestellt ist.

### Beschreibung des Ausführungsbeispiels

In der einzigen Figur ist ein Piezoelement 1 zur Bildung eines Piezoaktors gezeigt, der aus einer Piezofolie 2 eines Keramikmaterials mit einer geeigneten Kristallstruktur aufgebaut ist, so dass unter Ausnutzung des sogenannten Piezoeffekts bei Anlage einer äußeren elektrischen Spannung eine mechanische Reaktion des Piezoaktors in Richtung des Pfeiles 3 erfolgt.

Aus der Figur ist erkennbar, dass Piezolagen 4 durch eine Biegung der Piezofolie 2 gebildet sind, wobei die Keramikschicht zuvor in der Breite des Piezoelements 1 geschnitten worden ist und mit einem Lösungsmittel biegbar gemacht wurde. Die Piezofolie 2 wurde vor der Biegung auf beiden Seiten bis auf die vorgegebenen Endbereiche 5 metallisiert, damit sich Elektroden 6 und 7 herausbilden, die nach der Faltung jeweils wechselseitig als Innenelektroden 6 und 7 wirken. Der Abstand der Elektroden 6 und 7 zueinander weist hier den Betrag s auf, entsprechend der Dicke der Piezolagen 4 und entsprechen dem radialen Abstand der Innenelektroden 6, 7 im Biegebereich.

Nach einem Sinterprozess wird das gefaltete Paket der Piezolagen 4 mit Außenelektroden 8 und 9 versehen, die beim gezeigten Ausführungsbeispiel jeweils aus einer metallischen Wellelektrode bestehen. Im jeweiligen Biegebereich werden die Außenelektroden 8 und 9 mit der metallisierten Schicht auf den Piezolagen 4 elektrisch leitend verbunden, so dass eine elektrische Spannung auf die Innenelektroden 6 und 7 zur Erzeugung des Piezoeffekts aufbringbar ist.

Auf die äußeren Piezolagen 4 ist noch jeweils eine elektrisch isolierende Kopfplatte 10 und eine Fussplatte 11 aufgebracht, durch die das gesamte Piezoelement 1 nach außen hin abisoliert werden kann.

## Patentansprüche

1. Piezoelement mit einem Mehrschichtaufbau von Piezolagen (4) mit dazwischen angeordneten Elektroden (6, 7), wobei die einzelnen Piezolagen (4) ganz oder teilweise mit den elektrisch leitenden Elektroden (6, 7) versehen sind und wobei die Elektroden eine wechselseitige seitliche Kontaktierung über Außenelektroden (8, 9) aufweisen,
**dadurch gekennzeichnet,**
**dass** die einzelnen Piezolagen (4) aus einer während der Herstellung faltbaren durchgängigen Folie (2) bestehen, dass die Außenelektroden (8, 9) aus einem elektrisch leitenden Sieb oder Netz oder aus Wellelektroden bestehen und
**dass** der Mehrschichtaufbau der Piezolagen (4) jeweils am Ende der gefalteten Lagen mit einer elektrisch isolierenden Keramikplatte (10, 11) versehen ist.

2. Piezoelement nach Anspruch 1, **dadurch gekennzeichnet, dass** die Folie (2) durch Lösungsmittel biegbar ist und beidseitig bis auf einen vorgegebenen Bereich (5) an den Enden in Längsrichtung zur Herstellung der Elektroden (6, 7) metallisiert ist und dass jeweils außen im Biegebereich der gefalteten Folie (2) die Außenelektroden (8, 9) zur Bildung der wechselseitigen Kontaktierung an die metallisierte Schicht angebracht sind.

3. Piezoelement nach Anspruch 1 oder 2, **dadurch gekennzeichnet, dass** das Piezoelement (1) Bestandteil eines Piezoaktors ist, der zur Betätigung eines mechanischen Bauteils wie ein Ventil oder dergleichen heranziehbar ist.

4. Verfahren zur Herstellung eines Piezoelements nach einem der Ansprüche 1 bis 3, **dadurch gekennzeichnet, dass** die Piezofolie (2) in der Breite des Piezoelements (1) geschnitten und mit Lösungsmitteln biegbar gemacht wird, dass die Piezofolie (2) auf beiden Seiten bis auf die vorgegebenen Endbereiche (5) metallisiert wird, dass die Piezofolie (2) in vorgegebenen Abständen durch Biegung gefaltet wird, dass das gefaltete Paket nach dem Laminieren gesintert wird und dass die Außenelektroden (8, 9) mittels Löten auf die metallisierte Schicht im Biegebereich aufgebracht wird, und dass auf die äußeren Piezolagen (4) vor dem Sintern eine elektrisch isolierende Kopf- und Fußplatte (10, 11) aus Piezokeramik aufgebracht wird.

## Claims

1. Piezo element with a multiple-layer structure of piezo layers (4) and with electrodes (6, 7) arranged in between, the individual piezo layers (4) being completely or partially provided with the electrically conducting electrodes (6, 7) and the electrodes having lateral contacting on alternating sides by means of external electrodes (8, 9), **characterized in that** the individual piezo layers (4) comprise a continuous film (2) which can be folded during production, **in that** the external electrodes (8, 9) comprise an electrically conducting screen or mesh or comprise corrugated electrodes and **in that** the multiple-layer structure of the piezo layers (4) is respectively provided at the end of the folded layers with an electrically insulating ceramic sheet (10, 11).

2. Piezo element according to Claim 1, **characterized in that** the film (2) has been made flexible by solvent and, apart from a prescribed region (5) at the ends in the longitudinal direction, is metallized on both sides for producing the electrodes (6, 7) and **in that** the external electrodes (8, 9) are attached to the metallized layer respectively on the outside in the bending region of the folded film (2) to form the contacting on alternating sides.

3. Piezo element according to Claim 1 or 2, **characterized in that** the piezo element (1) is a component part of a piezo actuator which can be used for actuating a mechanical component such as a valve or the like.

4. Method for producing a piezo element according to one of Claims 1 to 3, **characterized in that** the piezo film (2) is cut to the width of the piezo element (1) and is made flexible by means of solvents, **in that**, apart from the prescribed end regions (5), the piezo film (2) is metallized on both sides, **in that** the piezo film (2) is folded at prescribed intervals by bending, **in that** the folded assembly is sintered after lamination and **in that** the external electrodes (8, 9) are applied to the metallized layer in the bending region by means of soldering, and **in that** an electrically insulating top sheet (10) and bottom sheet (11) of piezo ceramic are applied to the outer piezo layers (4) before the sintering.

## Revendications

1. Elément piézo-électrique à structure multicouche formée de couches piézo-électriques (4) pourvu d'électrodes (6, 7) intercalées entre elles, les différentes couches piézo-électriques (4) étant dotées complètement ou partiellement d'électrodes (6, 7) électriquement conductrices, électrodes présentant une mise en contact latérale réciproque via des électrodes extérieures (8, 9),
**caractérisé en ce que**
les différentes couches piézo-électriques (4) se composent d'une feuille (2) transparente pliable pendant la fabrication, les électrodes extérieures (8, 9) se composent d'un filtre ou d'un filet électriquement conducteur ou d'électrodes ondulées, et la structure multicouche des couches piézo-électriques (4) est pourvue d'une plaque en céramique (10, 11) électriquement isolante à l'extrémité des couches pliées.

2. Elément piézo-électrique selon la revendication 1,
**caractérisé en ce que**
la feuille (2) est rendue flexible par des solvants et elle est métallisée des deux côtés aux extrémités jusqu'à une zone donnée (5) dans la direction longitudinale pour fabriquer les électrodes (6, 7), et à l'extérieur dans la zone de flexion de la feuille pliée (2), les électrodes extérieures (8, 9) sont appliquées sur la couche métallisée pour la formation de la mise en contact réciproque.

3. Elément piézo-électrique selon la revendication 1 ou 2,
**caractérisé en ce que**
l'élément piézo-électrique (1) fait partie d'un actionneur piézo-électrique pouvant être utilisé pour actionner un composant mécanique comme une soupape ou similaire.

4. Procédé de fabrication d'un élément piézo-électrique selon l'une quelconque des revendications 1 à 3,
**caractérisé en ce qu'**
on coupe la feuille piézo-électrique (2) dans la largeur de l'élément piézo-électrique (1), on la rend flexible par des solvants, on métallise la feuille piézo-électrique (2) sur les deux côtés jusqu'aux zones terminales données (5), on plie la feuille piézo-électrique (2) par flexion à des intervalles donnés, le paquet plié est fritté après le laminage, et on applique les électrodes extérieures (8, 9) par brasage sur la couche métallisée dans la zone de flexion, avec une plaque de tête ou de pied (10, 11) en céramique piézo-électrique électriquement isolante appliquée sur les couches piézo-électriques extérieures (4) avant le frittage.
